Europäisches Patentamt

European Patent Office

Office européen des brevets

(19)

(11) Veröffentlichungsnummer: **0 119 627**
**B1**

# EUROPÄISCHE PATENTSCHRIFT

(12)

(45) Veröffentlichungstag der Patentschrift: 30.05.90

(21) Anmeldenummer: 84103010.9

(22) Anmeldetag: 19.03.84

(51) Int. Cl.⁵: **H 03 H 19/00,** H 03 C 1/00

(54) Als Schalter-Kondensator-(SC)-Filter ausgebildete Modulatorschaltung.

(30) Priorität: 22.03.83 DE 3310339

(43) Veröffentlichungstag der Anmeldung:
26.09.84 Patentblatt 84/39

(45) Bekanntmachung des Hinweises auf die
Patenterteilung:
30.05.90 Patentblatt 90/22

(84) Benannte Vertragsstaaten:
AT BE CH DE FR GB IT LI NL SE

(56) Entgegenhaltungen:
DE-A-3 126 020

IEEE TRANSACTIONS ON CIRCUITS AND
SYSTEMS, Band CAS-28, Nr. 6, Juni 1981,
Seiten 576-584, IEEE, New York, US; K. MARTIN
et al.: "Switched-capacitor building blocks for
adaptive systems"

(73) Patentinhaber: Siemens Aktiengesellschaft
Wittelsbacherplatz 2
D-8000 München 2 (DE)

(72) Erfinder: Betzl, Hermann, Dipl.-Ing.
Enzianstrasse 8
D-8122 Penzberg (DE)
Erfinder: Nossek, Josef A., Dr.
Waldstrasse 17
D-8127 Iffeldorf (DE)

(56) Entgegenhaltungen:

IEEE TRANSACTIONS ON CIRCUITS &
SYSTEMS, Band CAS-27, Nr. 6, Juni 1980,
Seiten 515-521, IEEE, New York, US; R.
GREGORIAN: "Switched-capacitor filter design
using cascaded sections"

## Beschreibung

Die Erfindung betrifft eine als Schalter-Kondensator-(SC)-Filter ausgebildete Modulatorschaltung gemäß dem Oberbegriff des Patentanspruchs 1.

Schaltungen der vorgenannten Art sind dem Grundkonzept aus der DE—A—3 126 020 und aus der Zeitschrift IEEE Transactions as Circuit and Systems Vol. CAS-28 (1981) Juni, Seiten 576—584 bekannt.

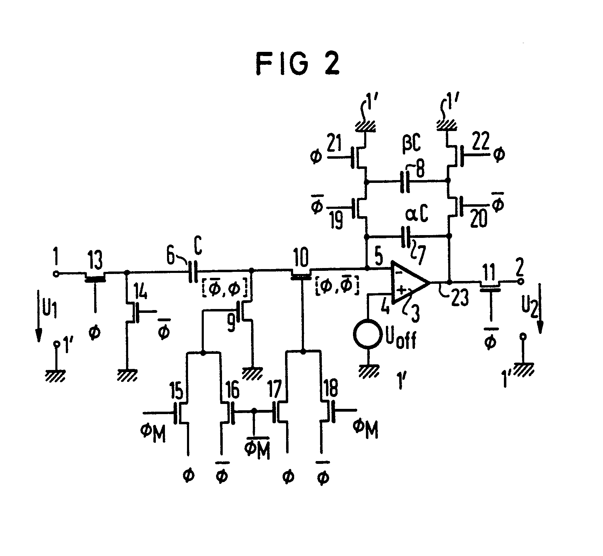

Obwohl die in der DE—A—3 126 020 angegebenen Modulatorschaltungen mit SC-Filterns, insbesondere was den Ausgangsschalter am Ausgang des als Integrator geschalteten Operationsverstärkers betrifft, nicht direkt mit Figur 2 nach der Anmeldung identisch ist, wird dort mit dem Operationsverstärker auch ein SC-Integrator gebildet (vgl. Figur 5a) und dem invertierenden Eingang des Opamps ein SC-Netzwerk vorgeschaltet, das aus einem in einer Taktphase geladenen Kondensator besteht, der seine Ladung während der Modulationsphasen mit entgegengesetzten Vorzeichen an den dem Operationsverstärker zugeordneten Integrationskondensator abgibt.

Zu dem gleichen Ergebnis gelant man mit Figur 12 und dem dazugehörigen Text in der Zeitschrift IEEE Transactions as Circuit and Systems Vol. CAS-28 (1981) Juni, Seiten 576—584.

Schalter-Kondensator-Filter sind unter anderem aus dem Aufsatz "Bilinear SC-Ladder Filters" in der Zeitschrift IEEE Trans. Cas Vol. 28, Seiten 811 bis 822, August 1981, von den Autoren M. S. Lee, G. C. Temes, C. Chang und M. B. Ghaderi beschrieben worden. Auch sind spezielle Schalter-Kondensator Filter aus der DE—C—30 01 969 bekannt. In dieser Patentschrift sind Beispiele dafür angegeben, z.B. Spulen und Parallelresonanzkreise durch Schalter-Kondensator-Anordnungen zu realisieren. Es handelt sich also bei diesen SC-Schaltungen um solche Schaltungen, die nicht zeitkontinuierliche Analogsignale im eingentlichen Sinne verarbeiten, sondern zeitdisrete Signale, die in Form von Abtastproben vorliegen, wobei die Abtastproben im Rhythmus einer Taktfrequenz fs erzeugt werden und über die Beziehung T=1/fs wird dementsprechend T die Taktperiode genannt. Schaltungen zur Erzeugung solcher Abtastproben sind für sich bekannt, so daß sie an dieser Stelle nicht im einzelnen erläutert werden müssen. Es ist jedoch auch im folgenden davon auszugehen, daß der dargestellten Schaltung solche Abtastschaltungen jeweils vor- bzw. nachgeschaltet sein können, so daß es also einerseits gelingt, aus einem Analogsignal entnommene Abtastproben der Filterschaltung eingangsseitig zuzuführen und die ausgangsseitig zur Verfügung stehenden Signale wieder in zeitkontinuierliche Analogsignale umzuwandlen. Der wesentliche technische Vorteil solcher Filter ist darin zu sehen, daß Spulen durch aktive Schalterelemente und Kondenstoren nachgebildet werden, so daß sie sich zur monolithischen Integration von größeren Filterschaltungen eignen. Als Verstärker werden dabei überwiegend die bekannten Operationsverstärker eingesetzt und es wird dabei angestrebt, einerseits eine möglichst geringe Anzahl von Schalterelementen anwenden zu müssen und andererseits auch die Stabilität solcher Schaltungen zu gewährleisten. Die Realisierung der Kondensatoren erfolgt in der Regel nach Art der sogenannten MOS-Technologie (Metall-Oxidsilizium-Technologie) und auch die Realisierung von Schaltern mit Hilfe von integrierten Schaltungen, denen zu vorgebbaren Taktphasen Schaltspannungen zugeführt werden, ist für sich bekannt.

Wegen der Möglichkeit, die Schaltungen in integrierter Form aufzubauen, wird man auch daran denken, Modulatorschaltungen in einer solchen Weise mit dem Filter zu verschalten, daß auch derartige Gesamtschaltungen einem integrierten Aufbau zugänglich sind.

Die Modulatorschaltungen müssen dabei ebenfalls in einem bestimmten Schalttakt (Trägerfrequenz) geschaltet, also getaktet werden, wodurch wiederum Störspannungen entstehen, die das zu verarbeitende Wechselsignal in nachteiliger Weise beeinflussen.

Aufgabe der Erfindung ist es deshalb, Filterschaltungen anzugeben, bei denen einerseits die Modulatoranordnung unmittelbar in die integrierbare Filterschaltung einbezogen ist, und bei denen die bekannte an sich störende Offsetspannung des Operationsverstärkers am Ausgang der Modulatorschaltung nur als Gleichspannung erscheint, und somit nicht mehr als Trägerrest das Wechselsignal stört.

Für die einleitend genannten SC-Filterschaltungen wird diese Aufgabe erfindungsgemäß nach den kennzeichnenden Merkmalen des Patentanspruches 1 gelöst.

Vorteilhafte Ausgestaltungen sind in den Unteransprüchen anzugeben.

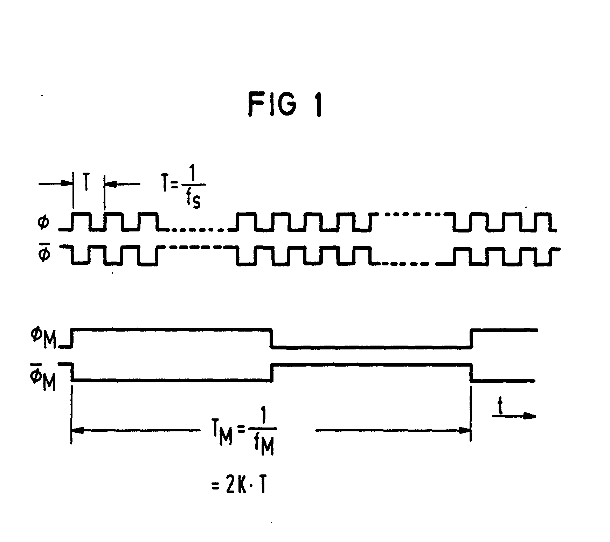

Anhand der Figuren 1 und 2 wird nachstehend die Erfindung noch näher erläutert.

Es zeigen in der Zeichnung

Fig. 1 ein Taktschema für Netzwerk- und Modulationstaktphasen (Ø, $\overline{Ø}$ und $Ø_M$, $\overline{Ø}_M$) sowie deren zeitliche Zuordnung;

Fig. 2 ein Schaltungsbeispiel.

In der beigefügten Figur 2 is das Bezugspotential mit der Bezugsziffer 1' versehen und man wählt in der Regel hierfür Massepotential, wie dies durch das zugehörige Massesymbol ebenfalls kenntlich gemacht wird. Eine Eingangsklemme ist mit 1 bezeichnet und es liegt also die Eingangsspannung $U_1$ zwischen der Klemme 1 und Massepotential. Die Ausgangsspannung $U_2$ kann zwischen der Ausgangsklemme 2 und Masspotential 1' abgenommen werden. In der Schaltung ist ferner ein Operationsverstärker 3 zu erkennen, dessen nichtinvertierender Eingang ("+") mit der Bezugsziffer 4 und dessen invertierender eingang ("—") mit der Bezugsziffer 5 bezeichnet sind. Zwischen dem nichtinvertierenden Eingang 4 und Massepotential ist symbolisch auch eine Spannungsquelle eingetragen, die die bei Operationsverstärkern bekanntlich auftretende Offsetspannung "$U_{off}$" darstellt. Auf die Eingangsklemme 1 folgt ein Schalter 13 im Längszweig, dem ein weiterer Schalter 14 im Querzweig folgt. Es schließt sich im Längszweig dann ein Kondensator 6 an, der die Kapazität C hat. Über einen weiteren Schalter 10 wird der invertierende Eingang 5 des Operationsverstärkers 3 und über einen Schalter 9 Bezugspotential 1' erreicht. Am Ausgang 23 des Operationsverstärkers 3 liegt ein Schalter 11, dem die Ausgangsklemme 2 folgt. Zwischen dem Ausgang 23 des Operationsverstärkers 3 und dem nichtinvertierenden Eingang 5 liegt ein Integrationskondensator 7, der die Kapazität $\alpha$C hat, als in einem zu bemessenden Verhältnis zum Kondensator C steht. Auf Bezugspotential geschaltet sind in diesem Zweig noch die Schalter 21 und 22. Dort liegt auch ein sogenannter Bedämpfungskondensator 8, dessen Kapazitätswert mit $\beta$C bezeichnet ist und der gewissermaßen parallel zum Kondensator 7 geschaltet ist, wobei jeweils die in der gleichen Taktphase $\bar{\emptyset}$ (siehe Fig. 1) geschalteten Schalter 19 und 20 dazwischen liegen. Die Schalter 21 und 22 werden während der Taktphase $\emptyset$ geschlossen.

Zwischen dem Kondensator 6 und dem Schalter 10 liegt ein nach Bezugspotential führender Schalter 9, dessen Schaltrhythmus wiederum über die Schalter 15 und 16 im Modulationstakt $\emptyset_M$ bzw. $\bar{\emptyset}$ gesteuert wird. Die Modulationstaktphasen $\bar{\emptyset}_M$ bzw. $\emptyset_M$ liegen auch über die Schalter 17 und 18 am Schalter 10. Die Schalter 15, 16, 17 und 18 schalten in abwechselnder Reihenfolge die Taktphase $\emptyset$ bzw. $\bar{\emptyset}$ durch. Während der einen Netzwerktaktphase $\emptyset$ schließen im Ausführungsbeispiel also die Schalter 13, 21 und 22. Während der Netzwerktaktphase $\bar{\emptyset}$ schließen die Schalter 14, 11, 19 und 20. Die Schalter 9 bzw. 10 können während der Netzwerktaktphasen $\emptyset$ oder $\bar{\emptyset}$ geschlossen sein. Weiterhin werden die Netzwerktaktphasen $\emptyset$ noch den Schaltern 15 und 17, die Taktphasen $\bar{\emptyset}$ den Schaltern 16 und 18 zugeführt. Diese Schalter werden mit der Modulatortaktphase $\emptyset_M$ bzw. $\bar{\emptyset}_M$ gesteuert. Durch diese Art der Schaltung wird somit eine Modulation erreicht und die Ausgangsspannung $U_2$ enthält in an sich bekannter Weise alle bei einer Modulation entstehenden Seitenbänder, von denen jeweils das für die Weiterverarbeitung gewünschte Band durch Filterschaltungen ausgesiebt werden muß.

Bezüglich der Wahl der Taktphasen sei auf folgendes hingewiesen. Die Taktphasen $\emptyset$ und $\bar{\emptyset}$ müssen selbstverständlich so gewählt sein, daß sie sich nicht überlappen. Entsprechend gilt das auch für die Modulatortaktphasen $\emptyset_M$ bzw. $\bar{\emptyset}_M$.

Bei der dargestellten Schaltung wird also gewissermaßen folgendes erreicht. Ein Schalterkondensatorfilter und ein Modulator sind miteinander so verschaltet, daß mit dem zugehörigen Operationsverstärker ein Integratornetzwerk gebildet wird. Weiterhin ist dem Operationsverstärker ein SC-Netzwerk vorgeschaltet, in dem ein Ladekondensator vorhanden ist, der im Beispiel mit der Bezugsziffer 6 bezeichnet ist, und der während der Integrator- bzw. Netzwerktaktphase $\emptyset$ geladen wird.

Durch die Modulatortaktphasen $\emptyset_M$ bzw. $\bar{\emptyset}_M$ wird der SC-Integrator zwischen nichtinvertierendem und invertierendem Betrieb umgeschaltet. Dabei wird entweder die Ladung des Kondensators 6 während der Taktphase $\bar{\emptyset}$ auf den Integrationskondensator 7 übertragen bzw. während der Taktphase $\emptyset$ unmittelbar der Ladestrom des Kondensators 6 auch über den Kondensator 7 geleitet.

Vorteilhaft ist es, wenn die Integrator- bzw. Netzwerktaktfrequenz fs ein geradzahliges Vielfaches der Modulationstaktfrequenz $f_M$ ist.

Der Kondensator 8 mit der Kapazität $\beta$C und die zugehörigen Schalter haben die Eigenschaft, daß der Kondensator 8 gewissermaßen als Bedämpfungsnetzwerk wirkt und der Integrationskondensator 7 teilweise entladen wird.

In der beschriebenen Anordnung sind also wie bereits erwähnt, Modulator und SC-Filter aufeinander abgestimmt und auch der Integrator miteinbezogen, so daß nur noch ein Operationsverstärker benötigt wird.

Für eine sehr hohe Leerlaufverstärkung des Operationsverstärkers erhält man:

$$U_2 = \pm \frac{z^{-1/2}}{\alpha + \beta - \alpha\, z^{-1}} \qquad \begin{bmatrix} \text{"--" während Phase } \emptyset_M \\ \text{"+" während Phase } \emptyset_M \end{bmatrix}$$

$$+ U_{off}\,(1 + 1/\beta)$$

Hierbei ist z die Funktionsvariable und $\alpha$ und $\beta$ die mit den Kondensatoren 6, 7 und 8 bereits erläuterten Kapazitätsverhältnisse.

Das vom abgetasteten Eingangssignal herrührende Ausgangssignal wechselt, wie gewünscht, das Vorzeichen. Die Offsetspannung des Operationsverstärkers 3 erscheint jedoch unabhängig von der Modulationstaktphase als Gleichsignal am Ausgang.

Die angegebene Formel zeigt auch, daß sich eine ideale Basisbandunterdrückung ergibt und daß keine Trägerreste in der Ausgangsspannung $U_2$ enthalten sind.

Bezüglich der gewählten Taktphasen sei noch folgendes erwähnt.

Beim analogen Modulator tritt an dessen Ausgang eine unbegrenzte Zahl von umgesetzten Frequenzbändern auf, deren Amplitude mit 1/n abnimmt.

Der mit der Frequenz $f_s$ getaktete "zeitdiskrete" Modulator hat dagegen—als zeitdiskretes System—ein mit $f_s$ periodisches Spektrum. Es kann aus der Überlagerung (aliasing) der jeweils $f_s/2$ breiten Teilbänder des Spektrums vom analogen modulierten Signal gewonnen werden. Wählt man für $f_s$ ein gerades, ganzzahliges Vielfaches der Modulatorfrequenz $f_M$, d.h. $f_s = 2K\, f_M$, K ganzzahlig, dann werden die Teilbänder

3

frequenzrichtig überlagert. Ein weiterer Vorteil bei dieser Wahl liegt darin, daß die Differenztöne $n_1 f_s \pm n_2 f_M$ Vielfache von $f_M$ sind und deshalb nicht ins umgesetzte Nutzband fallen können.

Darüber hinaus läßt sich die Zusammenfassung von Modulator und SC-Filter für beliebige Filtergrade durchführen, derart daß die beschriebene Schaltung (Fig. 2) den Eingangsintegrator des höhergradigen SC-Filters darstellt.

## Patentansprüche

1. Als Schalter-Kondensator-(SC)-filter ausgebildete Modulatorschaltung, die mit einem Modulationstakt ($\emptyset_M$, $\bar{\emptyset}_M$) betrieben wird, bestehend aus Schaltern, Kondensatoren und wenigstens einem Operationsverstärker (3), dessen nichtinvertierender Eingang (5) auf einem Bezugspotential (1') liegt, und bei der mit dem Operationsverstärker (3) ein mit zwei unterschiedlichen Taktphasen ($\emptyset$, $\bar{\emptyset}$) betriebener SC-Integrator gebildet ist, und bei der weiterhin dem invertierenden Eingang (5) des Operationsverstärkers (3) ein SC-Netzwerk vorgeschaltet ist, das aus einem während der Integrator- bzw. Netzwerk-Taktphase ($\emptyset$) geladenen Kondensator (6) besteht, der seine Ladung während der Modulationstaktphasen ($\emptyset_M$ bzw. $\bar{\emptyset}_M$) mit entgegengesetzten Vorzeichen an den dem Operationsverstärker (3) zugeordneten Integrationskondensator (7) abgibt, dadurch gekennzeichnet, daß der während der Integrator- bzw. Netzwerktaktphase ($\emptyset$) zu ladende Kondensator (6) unter Zwischenschaltung von Längszweig- bzw. Querzweig-Schaltern (13, 14) der Eingangsklemme (1, 1') nachgeschaltet ist, daß diesem Kondensator (6) ein Schalternetzwerk (15, 16, 17, 18) folgt, das im Rhythmus des Modulationstaktes ($\emptyset_M$ bzw. $\bar{\emptyset}_M$) die Netzwerktaktphasen ($\emptyset$ bzw. $\bar{\emptyset}$) einem Querzweigschalter (9) bzw. Längszweigschalter (10) alternierend zuführt, und daß der Längszweigschalter (10) an den invertierenden Eingang des Operationsverstärkers angeschaltet ist, daß im Filterausgang ein Schalter (11) vorgesehen ist, dem die Ausgangsklemmen (2, 1') folgen, und daß der Integrationskondensator (7) und ein Bedämpfungskondensator (8) zwischen den Ausgang (23) und den invertierenden Eingang (5) des Operationsverstärkers (3) geschaltet sind.

2. Schalter-Kondensator-Filter nach Anspruch 1, dadurch gekennzeichnet, daß die Integrator- bzw. Netzwerktaktfrqeuenzen ($f_s$) ein geradzahliges Vielfaches der Modulationstaktfrequenz ($f_M$) ist.

3. Schalter-Kondensator-Filter nach Anspruch 1 oder 2, dadurch gekennzeichnet, daß dem Operationsverstärker (3) ein Bedämpfungsnetzwerk (8, 21, 22) zugeordnet ist.

4. Schalter-Kondensator-Filter nach einem der vorhergehenden Ansprüche, dadurch gekennzeichnet, daß der SC-Integrator die Eingangsstufe eines Schalter-Kondensator-Filters höheren Grades bildet.

## Revendications

1. Circuit modulateur réalisé sous la forme d'un filtre à interrupteurs et condensateurs (SC), qui fonctionne avec une cadence de modulation ($\emptyset_M$, $\bar{\emptyset}_M$), et est constitué par des interrupteures, des condensateurs et au moins un amplificateur opérationnel (3), dont l'entrée non inverseuse (5) est placée à un potentiel de référence (1'), et dans lequel un intégrateur SC fonctionnant avec deux phases de cadence ($\emptyset$, $\bar{\emptyset}$) différentes est formé avec l'amplificateur opérationnel (3), et dans lequel, en outre, en amont de l'entrée inverseuse (5) de l'amplificateur opérationnel (3) est branché un réseau SC, qui est constitué par un condensateur (6), qui est chargé pendant la phase de cadence ($\emptyset$) de l'intégrateur ou du réseau et délivre sa charge pendant les phases de cadence de modulation ($\emptyset_M$ ou $\bar{\emptyset}_M$) avec des signes opposés, au condensateur d'intégration (7) associé à l'amplificateur opérationnel, caractérisé par le fait que le condensateur (6), qui doit être chargé pendant la phase ($\emptyset$) de l'intégrateur ou du réseau, est branché en aval de la borne d'entrée (1, 1') moyennant le montage intercalé d'interrupteurs (13, 14) situés dans la branche longitudinale ou dans la branche transversale, qu'en aval de ce condensateur (6) est monté un réseau d'interrupteurs (15, 16, 17, 18), qui envoie en alternance, au rythme de la cadence de modulation ($\emptyset_M$ ou $\bar{\emptyset}_M$), les phases de cadence du réseau ($\emptyset$ ou $\bar{\emptyset}$) à un interrupteur situé dans la branche transversale (9) ou à un interrupteur (10) situé dans la branche longitudinale, et que l'interrupteur (10) situé dans la branche longitudinale est raccordé à l'entrée inverseuse de l'amplificateur opérationnel, qu'à la sortie du filtre, il est prévu un interrupteur (11), en aval duquel sont disposées des bornes de sortie (2, 2'), et que le condensateur d'intégration (16) et un condensateur d'affaiblissement (8) sont branchés entre la sortie (23) et l'entrée inverseuse (5) de l'amplificateur opérationnel (3).

2. Filtre à interrupteurs et condensateurs suivant la revendication 1, caractérisé par le fait que les fréquences de cadence ($f_s$) de l'intégrateur ou du réseau sont égales à un multiple entier de la fréquence de cadence de modulation ($f_M$).

3. Filtre à interrupteurs et condensateurs suivant la revendication 1 ou 2, caractérisé par le fait qu'un réseau d'affaiblissement (8, 21, 22) est associé à l'amplificateur opérationnel (3).

4. Filtre à interrupteurs et condensateurs suivant l'une des revendications précédentes, caractérisé par le fait que l'intégrateur SC forme l'étage d'entrée d'un filtre à interrupteurs et condensateurs d'ordre supérieur.

## Claims

1. Modulator circuit realized as a switched capacitor (SC) filter, which is driven by a modulation clock

($\emptyset_M$, $\overline{\emptyset}_M$), comprising switches, capacitors and at least one operational amplifier (3) whose non-inverting input (5) is connected to a reference potential (1'), and in which an SC integrator driven by two different clock phases ($\emptyset$, $\overline{\emptyset}$) is formed with the operational amplifier (3), and in which there is furthermore upstream of the inverting input (5) of the operational amplifier (3) an SC network which consists of a capacitor (6) which is charged during the integrator or network clock phase ($\emptyset$), and which delivers its charge during the modulation clock phases ($\emptyset_M$ or $\overline{\emptyset}_M$) with opposite signs to the integration capacitor (7) associated with the operational amplifier (3), characterized in that the capacitor (6) to be charged during the integrator or network clock phase ($\emptyset$) is connected downstream of the input terminal (1, 1'), with intermediate connection of series arm and shunt arm switches (13, 14), in that following this capacitor (6) is a switch network (15, 16, 17, 18) which delivers the network clock phases ($\emptyset$ and $\overline{\emptyset}$) in an alternating manner in the rhythm of the modulation clock ($\emptyset_M$ and $\overline{\emptyset}_M$) to a shunt arm switch (9) and series arm switch (10) respectively, and in that the series arm switch (10) is connected to the inverting input of the operational amplifier, in that provided in the filter output is a switch (11) which is followed by the output terminals (2, 1'), and in that the integration capacitor (7) and an attenuation capacitor (8) are switched between the output (23) and the inverting input (5) of the operational amplifier (3).

2. Switched capacitor filter according to Claim 1, characterized in that the integrator or network clock frequencies ($f_s$) are an even-numbered multiple of the modulation clock frequency ($f_M$).

3. Switched capacitor filter according to Claim 1 or 2, characterized in that an attenuation network (8, 21, 22) is associated with the operational amplifier (3).

4. Switched capacitor filter according to one of the preceding claims, characterized in that the SC integrator forms the input stage of a higher-ranking switched capacitor filter.

# FIG 1

$$T = \frac{1}{f_S}$$

$$T_M = \frac{1}{f_M} = 2K \cdot T$$

FIG 2